# EUROPEAN PATENT APPLICATION

(11) **EP 3 422 389 A1**
(43) Date of publication of application: **02.01.2019**
(21) Application number: 17756136.2
(22) Date of filing: 02.02.2017
(51) Int. Cl.: H01L 21/28, H01L 21/336, H01L 29/12, H01L 29/78

(54) **OHMIC ELECTRODE**

(30) Priority: 24.02.2016 JP 2016032693; 26.04.2016 JP 2016088311
(71) Applicant: Kabushiki Kaisha Kobe Seiko Sho (Kobe Steel, Ltd.), Kobe-shi, Hyogo 651-8585 (JP)
(72) Inventor: GOTO, Hiroshi, Kobe-shi Hyogo 651-2271 (JP); SAKAMOTO, Hisatoshi, Kobe-shi Hyogo 651-2271 (JP)
(74) Representative: Müller-Boré & Partner Patentanwälte PartG mbB
(86) International application number: PCT/JP2017/003816
(87) International publication number: WO 2017/145694

(57) **Abstract**

An ohmic electrode that is used in, for example, a power semiconductor device including: a SiC substrate including an ohmic contact layer formed on a SiC semiconductor layer and formed of a material selected from the group consisting of nickel and nickel silicide, a barrier layer formed on the ohmic contact layer, and an electrode layer formed on the barrier layer and formed of a copper alloy containing at least one from among zinc, nickel, titanium, manganese, and calcium.

## Description

### TECHNICAL FIELD

The present invention relates to an ohmic electrode used in a SiC semiconductor device.

### BACKGROUND ART

SiC (silicon carbide) is a wide band gap semiconductor material and has high dielectric breakdown strength. Therefore, a SiC-containing MOSFET (MOS field-effect transistor) and the like are being developed as a next-generation power semiconductor device following a Si-IGBT (insulated gate bipolar transistor). An ohmic electrode (source/drain electrode) of the SiC-MOSFET includes an ohmic contact layer for forming an ohmic contact with a SiC substrate, and an electrode layer that is on the ohmic contact layer and has high electrically conductive properties. For the ohmic contact layer, for example, nickel silicide is used that is formed by subjecting Ni provided on the SiC substrate to a heat treatment at 800°C. For the electrode layer, an Al-based material such as Al or Al-Si is used that has high electrically conductive properties.

### SUMMARY OF THE INVENTION

### PROBLEMS TO BE SOLVED BY THE INVENTION

The SiC-MOSFET has an ohmic electrode through which a larger current flows than in the Si-IGBT, so that the SiC-MOSFET has had a problem with the Al-based material in terms of heat resistance and durability. Particularly, the current concentrates on a connection part with a bonding wire, so that the connection part is probably locally heated up to 600°C or higher. Another problem has been that the SiC-MOSFET becomes relatively high temperature during its operation to cause a difference in coefficient of thermal expansion between the SiC substrate and the ohmic electrode and thus apply shear stress to the ohmic electrode, generating a crack and peeling with the Al-based material.

Therefore, an object of the present invention is to provide an ohmic electrode that is used in a power semiconductor device including a SiC substrate, has good electrically conductive properties, is excellent in heat resistance and durability, and has high mechanical strength.

### MEANS FOR SOLVING THE PROBLEMS

The inventors have conducted earnest studies and have found as a result of the studies that a good ohmic electrode is obtained by using, as a material for the electrode layer, a Cu-Zn, Cu-Ni, Cu-Ti, Cu-Ca, or Cu-Mn alloy and forming a barrier layer to prevent diffusion of an ohmic contact material. Thus, the present invention has been completed.

That is, the present invention is directed to an ohmic electrode that is used in a SiC semiconductor device, the ohmic electrode including an ohmic contact layer that is formed on a SiC semiconductor layer and is formed of a material selected from the group consisting of nickel and nickel silicide, a barrier layer formed on the ohmic contact layer, and an electrode layer that is formed on the barrier layer and is formed of a copper alloy containing at least one from among zinc, nickel, titanium, manganese, and calcium.

The present invention is also a SiC semiconductor device including such an ohmic electrode.

### EFFECTS OF THE INVENTION

According to the present invention, it is possible to provide an ohmic electrode for a SiC semiconductor device that has good electrically conductive properties, is excellent in heat resistance and durability, and has high mechanical strength.

### BRIEF DESCRIPTION OF THE DRAWINGS

Fig. 1 is a sectional view of a SiC-MOSFET according to an embodiment of the present invention,
Fig. 2 shows electrical resistivity of Cu electrode layers each formed on a barrier layer before and after a heat treatment,
Fig. 3 is a SEM photograph showing a surface of a Cu electrode layer after a heat treatment,
Fig. 4 is a SEM photograph showing a surface of a Cu alloy electrode layer after a heat treatment,
Fig. 5 is a SEM photograph showing a surface of a Cu electrode layer formed on nickel silicide after a heat treatment,
Fig. 6 is a SEM photograph showing a surface of an Al-based electrode layer after a heat treatment,
Fig. 7 is a SEM photograph showing a surface of No. B-9 (Cu/Mo/NiSi) after a heat treatment at 600°C for 5 minutes, and
Fig. 8 is a SEM photograph showing a surface of No. B-11 (Cu-Zn/Mo/NiSi) after a heat treatment at 600°C for 5 minutes.

### EMBODIMENT OF THE INVENTION

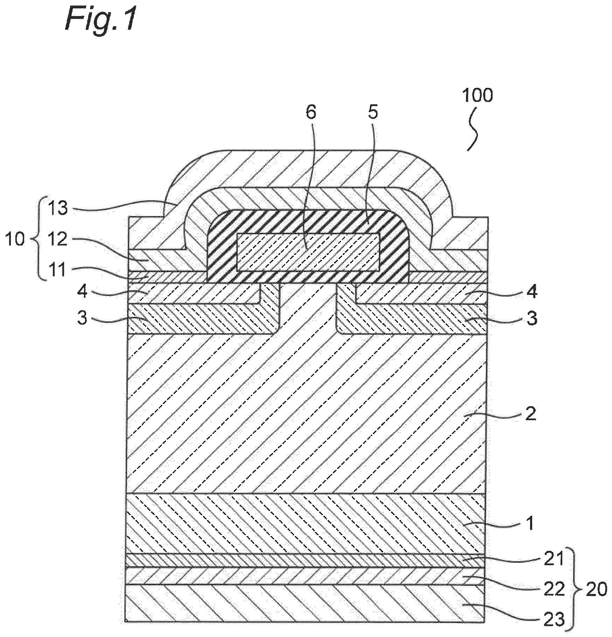

Fig. 1 is a sectional view of a SiC-MOSFET according to an embodiment of the present invention, generally represented by 100. The SiC-MOSFET 100 includes an n-type SiC substrate 1. An epitaxial layer (drift layer) 2 formed of n⁺SiC is provided on the SiC substrate 1. An insulating film 5 formed of, for example, silicon oxide, is provided on the epitaxial layer 2, and a gate electrode 6 formed of, for example, polysilicon is provided on the insulating film. Here, the gate electrode 6 is covered around with the insulating film 5.

A p-type region 3 is provided in the epitaxial layer 2 and on both sides of the gate electrode 6, and an n-type region 4 is provided in the p-type region 3. The p-type region 3 and the n-type region 4 are formed by selectively introducing an impurity into the epitaxial layer 2 according to, for example, an ion implantation method or a thermal diffusion method.

An ohmic contact layer 11 is provided on the n-type region 4. The ohmic contact layer 11 is formed of, for example, nickel silicide and has a film thickness of, for example, 100 nm.

The ohmic contact layer 11 is formed by, for example, forming a Ni film on the n-type region 4 formed of SiC according to a sputtering method and then subjecting the Ni film to a heat treatment for a reaction of Si with Ni.

Below is one example of each of the sputtering conditions and the annealing conditions applied for producing the ohmic contact layer 11.

### <Sputtering conditions>

Sputtering gas: argon
Gas pressure: 2 mTorr
Power: RF 400 W

### <Annealing conditions>

Temperature: 800°C
Atmosphere: nitrogen

In order to confirm formation of nickel silicide as a result of the reaction of Si in SiC with Ni under the annealing conditions described above, the following experiment was performed. First, a thermal oxide film (silicon oxide film) having a film thickness of 100 nm was formed on a Si substrate, and a sputtering layer having a film thickness of 100 nm was formed on the thermal oxide film by simultaneous discharge using a Ni target and a single-crystal Si target. The sputtering conditions are as follows.

### <Sputtering conditions>

Sputtering gas: argon
Gas pressure: 2 mTorr
Power: RF 150 W (Ni target) and DC 400 W (Si target)

Subsequently, the sputtering layer was subjected to a heat treatment under the annealing conditions (800°C, nitrogen atmosphere) described above and then to X-ray diffraction. This result clarified that the sputtering layer was formed into nickel silicide (Ni₂Si, NiSi) and demonstrated that the ohmic contact layer 11 was formed into nickel silicide under the annealing conditions described above.

In the SiC-MOSFET 100, the ohmic contact layer 11 is usually formed into nickel silicide by annealing at 800°C or higher. Part of the Ni layer, however, is not sometimes formed into silicide to leave Ni on a surface of the ohmic contact layer 11 depending on the film thickness of the Ni layer, the heat treatment time, or the heat treatment temperature.

The ohmic contact layer 11 is preferably formed of nickel silicide. The ohmic contact layer 11, however, may be formed of Ni, in addition to the case where part of the Ni layer is not formed into silicide and Ni remains as described above.

A barrier layer 12 is provided on the ohmic contact layer 11 to prevent mutual diffusion between the material for the ohmic contact layer 11 and a material for an electrode layer 13 formed on the barrier layer 12. As a material for the barrier layer 12, Mo is used, for example. Cu contained in the electrode layer 13 forms an all proportional solid solution with Ni contained in the ohmic contact layer 11 to easily generate mutual diffusion. Cu, however, forms no solid solution with Mo to hardly generate mutual diffusion. The mutual diffusion decreases conductivity of Cu and easily allows formation of a brittle mutual diffusion layer in an interface to degrade performance of the SiC-MOSFET 100. Used as the material for the barrier layer 12 is, for example, Ta, W, Nb, Ti, or nitrides of these elements, in addition to Mo. Particularly, TiN that exhibits excellent electrically conductive properties is suitable for the barrier layer 12. The barrier layer 12 has a film thickness of, for example, 50 nm. The film thickness may be selected within a range from 10 nm as a lower limit to 100 nm as an upper limit.

A sputtering method is used for producing the barrier layer 12 and the film formation conditions when Mo is used as the material are as follows, for example.

### <Sputtering conditions>

Sputtering gas: argon
Gas pressure: 2 to 10 mTorr
Power: DC 260 to 500 W

The film formation conditions when Ta, W, or Nb is used as the material are as follows, for example.

### <Sputtering conditions>

Sputtering gas: argon
Gas pressure: 2 mTorr
Power: DC 260 to 500 W

The film formation conditions when Ti is used as the material are as follows, for example.

### <Sputtering conditions>

Sputtering gas: argon, nitrogen
Gas pressure: 2 mTorr
Power: DC 260 to 500 W

Use of a nitride of Mo, Ta, W, Nb, or Ti as the material for the barrier layer 12 has also been confirmed to be capable of preventing diffusion from the ohmic contact layer 11 in the heat treatment. A nitride film is formed into amorphousness to give no grain boundary as a diffusion path of an element, so that an effect of suppressing the diffusion is considered to be enhanced.

When molybdenum nitride is used as the material for the barrier layer 12, molybdenum nitride is produced using a molybdenum target and using a mixed gas of argon with nitrogen as a sputtering gas under the following sputtering conditions.

### <Sputtering conditions>

Sputtering gas: argon + nitrogen (flow rate of nitrogen gas to whole gas: 30%)
Gas pressure: 2 mTorr
Power: DC 500 W

When titanium nitride is used as the material for the barrier layer 12, titanium nitride is produced using a titanium target and using a mixed gas of argon with nitrogen as a sputtering gas under the following sputtering conditions.

### <Sputtering conditions>

Sputtering gas: argon + nitrogen (flow rate of nitrogen gas to whole gas: 50 to 90%)
Gas pressure: 2 mTorr
Power: DC 500 to 1000 W

The electrode layer 13 is formed on the barrier layer 12. The electrode layer 13 is formed of, for example, an alloy of Cu and Zn (Cu-Zn), an alloy of Cu and Ni (Cu-Ni), an alloy of Cu and Ti (Cu-Ti), an alloy of Cu and Al (Cu-Al), an alloy of Cu and Ca (Cu-Ca), or an alloy of Cu and Mn (Cu-Mn). The electrode layer 13 has a film thickness of, for example, 300 to 4000 nm and is produced under the following conditions according to, for example, a sputtering method.

### <Sputtering conditions>

Sputtering gas: argon
Gas pressure: 2 mTorr
Power: DC 260 to 500 W

The ohmic contact layer 11, the barrier layer 12, and the electrode layer 13 that are formed as described above form a source electrode 10 of the SiC-MOSFET 100.

In the same manner as the source electrode 10, an ohmic contact layer 21, a barrier layer 22, and an electrode layer 23 are sequentially produced also on a back surface of the SiC substrate 1 to form a drain electrode 20. Thus, the SiC-MOSFET 100 is completed.

As described above, in the SiC-MOSFET 100 according to the embodiment of the present invention, the Cu alloy (Cu-Zn, Cu-Ni, Cu-Ti, Cu-Al, Cu-Ca, or Cu-Mn) that has good electrically conductive properties, thermally conductive properties, high heat resistance and mechanical strength has been used as the material for the electrode layers 13 and 23, in place of the Al-based material (such as Al or Al-Si) that has been conventionally used.

Further, in association with the use of the Cu alloy as the material for the electrode layers 13 and 23, the barrier layers 12 and 22 have been provided between the ohmic contact layer 11 and the electrode layer 13 and between the ohmic contact layer 21 and the electrode layer 23, respectively, to prevent mutual diffusion between the ohmic contact layers and the electrode layers, particularly diffusion of Ni from the ohmic contact layers 11 and 21 into the electrode layers 13 and 23.

This enables provision of an ohmic electrode for a SiC-MOSFET including an ohmic electrode that has good electrically conductive properties, is excellent in heat resistance and durability, and has high mechanical strength; and a SiC-MOSFET including such an ohmic electrode.

Here, the SiC-MOSFET has been described. The ohmic electrode described above, however, can also be applied to another SiC-based semiconductor device such as a schottky barrier diode.

Next, thermal stability is studied of source electrodes 10 with the material for the barrier layer 12 changed. Samples were each formed by producing an ohmic contact layer 11 formed of nickel silicide on a SiC substrate 1, then producing a barrier layer 12 formed of Ti, Ni, Mo, or Ta on the ohmic contact layer 11, and producing a Cu electrode layer 13 on the barrier layer 12. The barrier layer 12 and the electrode layer 13 were made to have film thicknesses of 50 nm and 4000 nm, respectively. As a comparative example, a sample was also formed by stacking a Cu electrode layer 13 directly on an ohmic contact layer 11.

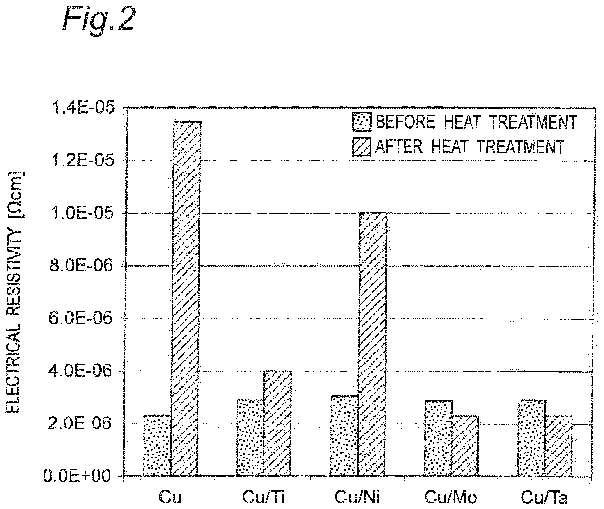

As the heat treatment conditions, the temperature was set to 450°C that is estimated as the temperature applied in a process of manufacturing a general semiconductor device. The heat treatment was performed in a nitrogen atmosphere for 1 hour. The electrode layers 13 were measured for electrical resistivity before and after the heat treatment and the effect of the barrier layers 12 was evaluated. Fig. 2 shows a change in electrical resistivity of the electrode layers 13 before and after the heat treatment.

In Fig. 2, the horizontal axis represents the samples and the vertical axis represents the values of electrical resistivity of the samples before and after the heat treatment. Each of the samples that includes the barrier layer formed of Ti, Ni, Mo, or Ta is denoted by Cu/Ti, Cu/Ni, Cu/Mo, or Cu/Ta. Cu on the left end of the horizontal axis denotes the sample of the comparative example that was formed by producing the Cu electrode layer 13 directly on the ohmic contact layer 11.

As is clarified by Fig. 2, only the sample (Cu/Ni) that included the barrier layer formed of Ni remarkably increased the electrical resistivity, but the samples formed of the other materials (Cu/Ti, Cu/Mo, and Cu/Ta) were capable of preventing an increase in electrical resistivity caused by the heat treatment.

On the other hand, as shown by the comparative example, the sample (Cu) included no barrier layer formed severely increased the electrical resistivity of the electrode layer 13 from 2.1 × 10⁻⁶ Ωcm to 1.35 × 10⁻⁵ Qcm. This electrical resistivity is larger than the electrical resistivity of the sample (Cu/Ni) that underwent the heat treatment. This clarifies that diffusion of Ni into the electrode layer 13 is more remarkable when the electrode layer is on nickel silicide than on Ni, and this fact has been demonstrated by actually analyzing the electrode layer 13.

An increase in electrical resistivity of the electrode layer 13 increases a loss during energization to significantly deteriorate conversion efficiency of the SiC-MOSFET. Further, heat generation in the electrode layer 13 degrades device characteristics or decreases thermal conductivity correlated with the electrical resistivity to decrease thermal conduction in spite of using Cu high in thermally conductive properties for the electrode layer and further to possibly accelerate degradation of the device.

With use of Mo, Ti, or Ta as the material for the barrier layer, however, it is possible to prevent the diffusion of Ni from the ohmic contact layer 11 into the electrode layer 13 to give an electrode layer 13 having good electrical resistivity even after the heat treatment, thus enabling formation of an electrode layer 13 excellent in electrically conductive properties and thermally conductive properties.

Next, as regards a sample (Cu/Mo) that included a barrier layer 12 formed of Mo and samples that each included the same barrier layer 12 and an electrode layer 13 formed of a Cu-Zn alloy (Cu-0.1 at% Zn, Cu-1 at% Zn, Cu-2 at% Zn, or Cu-5 at% Zn), surface state of the electrode layers 13 that underwent a heat treatment were observed. The heat treatment conditions are the same as in the case of Fig. 2, i.e., 450°C for 1 hour.

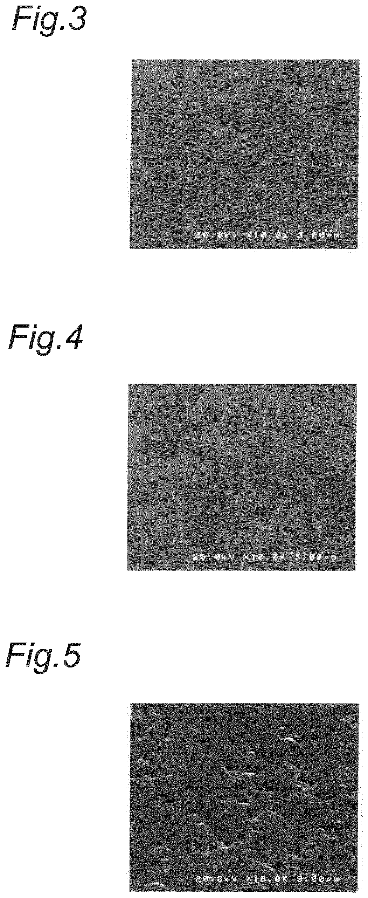

Fig. 3 is a SEM photograph showing a surface of the sample (Cu/Mo) that includes the electrode layer 13 formed of Cu, and Fig. 4 is a SEM photograph showing a surface of the sample (Cu-1 at% Zn/Mo) that includes the electrode layer 13 formed of a Cu-Zn (Cu-1 at% Zn) alloy. Fig. 3 shows generation of voids along grain boundaries on the surface of the electrode layer 13. Fig. 4, however, shows no such void observed. These facts clarify that because the generation of voids causes a decrease in heat resistance, addition of Zn to Cu as the material for the electrode layer 13 suppresses the generation of voids during the heat treatment and improves the heat resistance.

Table 1 summarizes the electrical resistivity and the heat resistance of various samples that underwent a heat treatment. Here, the ohmic contact layer 11 was formed of Ni, and the heat treatment conditions were set to 450°C for 1 hour. The evaluation of electrical resistivity was conducted according to the value of electrical resistivity of the electrode layer 13 that underwent the heat treatment, and a value of 4.0 × 10⁻⁶ Ωcm or less was evaluated as acceptable (○) and a value of more than 4.0 × 10⁻⁶ Ωcm was evaluated as unacceptable (×). The evaluation of heat resistance was conducted by observing with a SEM the electrode layer 13 that underwent the heat treatment, and the electrode layer that had no grain boundary void observed on a surface thereof was evaluated as acceptable (○) and the electrode layer that had a grain boundary void observed on a surface thereof was evaluated as unacceptable (×).

**[Table 1]**

| Structure | Electrical resistivity (Ωcm) | | Electrical resistivity | Heat resistance | Content rate of barrier layer component detected in electrode layer |
|---|---|---|---|---|---|
| | As-depo. | After heat treatment | | | |
| Cu/Mo/Ni | 2.00E-06 | 2.00E-06 | ○ | × | 0at% |
| Cu/Ta/Ni | 2.00E-06 | 2.10E-06 | ○ | × | 0at% |
| Cu/W/Ni | 2.00E-06 | 2.00E-06 | ○ | × | 0at% |
| Cu/Nb/Ni | 2.00E-06 | 2.00E-06 | ○ | × | 0at% |
| Cu-0.1at%Zn/Mo/Ni | 2.20E-06 | 2.10E-06 | ○ | ○ | 0at% |
| Cu-1at%Zn/Mo/Ni | 3.30E-06 | 2.30E-06 | ○ | ○ | 0at% |
| Cu-2at%Zn/Mo/Ni | 4.20E-06 | 2.70E-06 | ○ | ○ | 0at% |
| Cu-3at%Zn/Mo/Ni | 5.50E-06 | 3.30E-06 | ○ | ○ | 0at% |
| Cu-5at%Zn/Mo/Ni | 7.70E-06 | 4.90E-06 | × | ○ | 0at% |
| Cu-0.1at%Ni/Ni | 2.20E-06 | 2.00E-06 | ○ | ○ | 0at% |
| Cu-1at%Ni/Mo/Ni | 3.50E-06 | 2.70E-06 | ○ | ○ | 0at% |
| Cu-2at%Ni/Mo/Ni | 4.60E-06 | 3.30E-06 | ○ | ○ | 0at% |
| Cu-3at%Ni/Mo/Ni | 6.00E-06 | 4.20E-06 | × | ○ | 0at% |
| Cu-0.1at%Ti/Mo/Ni | 2.50E-06 | 2.40E-06 | ○ | ○ | 0at% |
| Cu-0.5at%Ti/Mo/Ni | 3.80E-06 | 3.50E-06 | ○ | ○ | 0at% |
| Cu-1at%Ti/Mo/Ni | 4.50E-06 | 4.00E-06 | × | ○ | 0at% |

The electrical resistivity never largely increases from before to after the heat treatment by using the barrier layer 12 formed of, for example, Mo. The electrical resistivity, however, is large in the sample Cu-5 at% Zn due to a large ratio of Zn. In the meantime, no barrier layer component was observed in the electrode layers 13.

Ni forms an all proportional solid solution with Cu, but forms no solid solution with Mo, and forms a compound with tungsten or niobium. That is, it is preferable to use, as the material for the barrier layer 12, a material that is non-solid soluble with Cu, that is, a material that forms no solid solution with Cu, or a material that forms a compound with Cu.

As to the heat resistance, grain boundary voids were observed on any of the electrode layers 13 formed of Cu, but addition of Zn to Cu in an amount of 0.1 to 5 at% suppressed generation of surface voids.

As shown in Table 1, the electrode layers 13 formed of Cu generate grain boundary voids by the heat treatment. On the other hand, when the barrier layer 12 is not used, a constituent element diffused from the ohmic contact layer 11 into the Cu electrode has been confirmed to eventually improve the heat resistance of the Cu electrode layer. In Table 1, however, the diffusion of the constituent element from the ohmic contact layer 11 is considered to have been completely suppressed by the barrier layer 12 to generate grain boundary voids and thus make the heat resistance insufficient.

As a material having heat resistance to the heat treatment described above, there can be exemplified Cu-1 at% Ni and Cu-1 at% Ti, in addition to Cu-1 at% Zn in Table 1. The heat treatment generates a protrusion on a surface of the electrode layer formed of Cu-1 at% Ti but gives flatness on a surface of the electrode layer formed of Cu-1 at% Ni as in the case of the electrode layer formed of Cu-1 at% Zn.

In the meantime, it has also been confirmed that it is possible to suppress grain boundary voids by using, as the material for the electrode layer 13, Cu-1 at% Ni described above, Cu-0.15 at% Ni-0.2 at% Nb, Cu-0.15 at% Ni-0.2 at% Al, or Cu-0.15 at% Ni-0.2 at% Mn, in addition to the samples indicated in Table 1.

Table 2 shows comparative examples of an electrode that has a structure including no barrier layer 12, and Ni, Ti, Al, NiSiₓ (nickel silicide), and TiSiₓ (titanium silicide) were used as the materials for the ohmic contact layer 11. Used as the materials for the electrode layer 13 were Cu, a Cu-Ni alloy, and a Cu-Ti alloy. The heat treatment conditions are the same as in Table 1, i.e., 450°C for 1 hour.

The evaluation of electrical resistivity was conducted in the same manner as in Table 1 according to the value of electrical resistivity of the electrode layer 13 that underwent the heat treatment, and a value of 4.0 × 10⁻⁶ Qcm or less was evaluated as acceptable (○) and a value of more than 4.0 × 10⁻⁶ Qcm was evaluated as unacceptable (×). The evaluation of heat resistance was conducted by observing with a SEM a surface of the electrode layer 13 that underwent the heat treatment, and the electrode layer that had no grain boundary void observed on the surface thereof was evaluated as ○, the electrode layer that had a grain boundary void observed on the surface thereof was evaluated as ×, the electrode layer that had a protrusion observed on the surface thereof was evaluated as ▲, and the electrode layer that had abnormal diffusion observed on the surface thereof was evaluated as Δ.

**[Table 2]**

| Structure | Electrical resistivity before heat treatment | Electrical resistivity after heat treatment | Content rate of barrier layer component detected in electrode layer | Heat resistance |
|---|---|---|---|---|
| Cu/Ni | ○ | × | 5.5at% | ○ |
| Cu/Ti | ○ | × | 4.1at% | ▲ |
| Cu/Al | ○ | × | 5.3at% | ○ |
| Cu-0.1at%Ni/Ni | ○ | × | 4.9at% | ○ |
| Cu-1at%Ni/Ni | ○ | × | 6.7at% | ○ |
| Cu-2at%Ni/Ni | × | × | 8.8at% | ○ |
| Cu-0.1at%Ti/Ti | ○ | × | 4.4at% | ▲ |
| Cu-1at%Ti/Ti | × | × | 5.1at% | ▲ |
| Cu-2at%Ti/Ti | × | × | 9.5at% | ▲ |
| Cu-0.1at%Al/Al | ○ | × | 5.3at% | ○ |
| Cu-1at%Al/Al | ○ | × | 4.9at% | ○ |
| Cu-2at%Al/Al | × | × | 6.3at% | ○ |
| Cu/NiSix | ○ | × | >10at% | Δ |
| Cu/TiSix | ○ | × | >6at% | Δ |
| Cu-0.1at%Ni/NiSi | ○ | × | >10at% | Δ |
| Cu-1at%Ni/NiSi | ○ | × | >10at% | Δ |
| Cu-2at%Ni/NiSi | × | × | >10at% | Δ |
| Cu-0.1at%Ti/TiSi | ○ | × | >10at% | Δ |
| Cu-1at%Ti/TiSi | × | × | >10at% | Δ |
| Cu-2at%Ti/TiSi | × | × | >10at% | Δ |

The electrical resistivity after the heat treatment was larger than 4.0 × 10⁻⁶Ωcm in any comparative examples.

On the other hand, as is clarified when Table 2 is compared with Table 1, the electrodes containing Cu as the material for the electrode layer 13 were improved in heat resistance. This is considered to be because the electrodes included no barrier layer 12 to allow the diffusion of the constituent element of the ohmic contact layer 11 into the electrode layer 13. The electrode that included the ohmic contact layer 11 formed of Ti, however, had a protrusion observed on the surface of the electrode that underwent the heat treatment. This is because Ti diffused into Cu formed a compound with Cu, and the compound was generated as a protrusion on the surface.

The electrodes that included the ohmic contact layer 11 formed of silicide (NiSi or TiSi) were confirmed to have a large defect as shown in the SEM photograph of Fig. 5 showing a surface of an electrode layer. This is considered to be due to abnormal diffusion from silicide.

The results in Table 2 clarify that the electrode that contains Cu or a Cu alloy as the material for the electrode layer 13 is not practical without the barrier layer 12 in consideration of both the electrical conductivity and the heat resistance after the heat treatment.

The SiC-MOSFET is sometimes used in a use environment at higher temperature depending on the operation conditions. Thus, studied below are the results of samples that underwent a heat treatment at 450°C for 30 minutes or a heat treatment at 600°C for 5 minutes.

First, in order to evaluate the heat resistance of the electrode layer 13 formed of a conventional Al-based material, an Al-based film (Al-1 at% Si film) was formed by sputtering on a thermal oxide film (silicon oxide film) that was produced on a surface of a silicon substrate and had a film thickness of 100 nm, and then subjected to the heat treatment at 450°C for 30 minutes or the heat treatment at 600°C for 5 minutes. A surface state of the Al-based film in either heat treatment was observed.

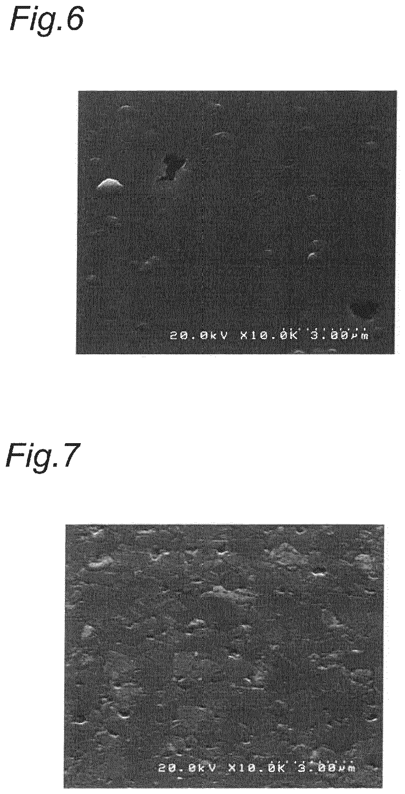

Fig. 6 is a SEM photograph showing a surface of the Al-based electrode layer that underwent the heat treatment at 600°C for 5 minutes. The Al-based electrode layer had no abnormality observed on the surface thereof in the heat treatment at 450°C for 30 minutes, whereas the Al-based electrode layer generated a hillock as shown in Fig. 6 when undergoing the heat treatment at 600°C for 5 minutes. Thus, the electrode layer 13 formed of the Al-based material does not give heat resistance to 600°C or higher.

Further, even when a barrier film is provided between the Al-based electrode layer and the thermal oxide film, the Al-based electrode layer generated a hillock on a surface thereof in the same manner. The conventional Al-based (Al-1 at% Si) electrode layer 13 generates mutual diffusion between the electrode layer and the material for the ohmic contact layer 11, such as Ni or NiSi. Further, provision of the barrier layer 12 formed of Mo or TiN between the electrode layer 13 and the ohmic contact layer 11 is capable of reducing the mutual diffusion, but it is impossible to prevent diffusion of Ni with the barrier layer 12 formed of Ti.

In order to solve these problems, a Cu-based material is used for the electrode layer 13 to give, with appropriate selection of a barrier layer 12, an electrode layer 13 having good electrical resistivity even after a heat treatment, i.e., in a high temperature environment not only at 450°C but also at 600°C, thus enabling formation of an electrode layer 13 excellent in electrically conductive properties and thermally conductive properties.

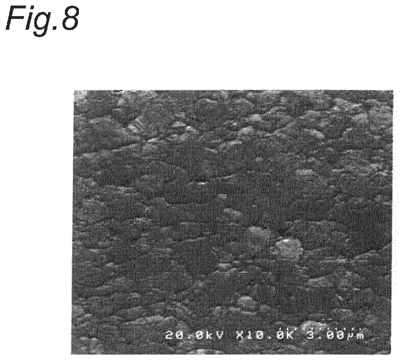

Fig. 7 is a SEM photograph of a surface of a sample (No. B-9 in Table 3) that contained Cu/Mo/NiSi for the electrode layer 13/barrier layer 12/ohmic contact layer 11 and underwent the heat treatment at 600°C for 5 minutes. Fig. 8 is a SEM photograph of a surface of a sample (No. B-11 in Table 3) that contained Cu-Zn/Mo/NiSi for the electrode layer 13/barrier layer 12/ohmic contact layer 11 and underwent the heat treatment at 600°C for 5 minutes.

Fig. 7 clarifies generation of voids along grain boundaries in the Cu electrode layer 13. The generation of voids is more remarkable than in the case of the heat treatment at 450°C for 30 minutes. In contrast, Fig. 8 clarifies reduction of generation of voids in the Cu-Zn electrode layer 13. These facts clarify that because the generation of voids causes a decrease in heat resistance of the electrode layer 13, addition of Zn to Cu as the material for the electrode layer 13 suppresses the generation of voids during the heat treatment and improves the heat resistance.

Table 3 shows the evaluation results of electrical resistivity and heat resistance of various samples including the two samples described above that underwent the heat treatment at 450°C for 30 minutes or the heat treatment at 600°C for 5 minutes. Here, all the samples included a SiO₂ film formed on a Si substrate and included a structure in Table 3 formed on the SiO₂ film. The ohmic contact layer 11 was formed of Ni or nickel silicide (NiSi), and the heat treatment conditions were set to 450°C for 30 minutes or 600°C for 5 minutes.

The evaluation of electrical resistivity was conducted according to the value of electrical resistivity of the electrode layer 13 that underwent the heat treatment, and a value of 4.0 × 10⁻⁶ Ωcm or less was evaluated as acceptable (○) and a value of more than 4.0 × 10⁻⁶ Ωcm was evaluated as unacceptable (×). The evaluation of heat resistance was conducted by observing with a SEM the electrode layer 13 that underwent the heat treatment, and the electrode layer that had no grain boundary void observed on a surface thereof was evaluated as acceptable (○), the electrode layer that had a grain boundary void observed on a surface thereof was evaluated as unacceptable (×), the electrode layer that had a protrusion observed on a surface thereof was evaluated as unacceptable (▲), and the electrode layer that had abnormal diffusion observed on a surface thereof was evaluated as unacceptable (Δ).

**[Table 3]**

| No. | Structure | Electrical resistivity Ωcm | | | Electrical resistivity | | Heat resistance | |
|---|---|---|---|---|---|---|---|---|
| | | As-depo. | After heat treatment at 450°C | After heat treatment at 600°C | 450°C | 600°C | 450°C | 600°C |
| A-1 | Al/Ni | 4.2E-06 | 4.2E-06 | 1.5E-05 | × | × | ▲ | ▲ |
| A-2 | Al/NiSi | 4.4E-06 | 1.0E-05 | 9.6E-06 | × | × | ▲ | ▲ |
| A-3 | Al/Ti/Ni | 3.7E-06 | 1.8E-05 | 1.9E-05 | × | × | Δ | Δ |
| A-4 | Al/Ti/NiSi | 3.7E-06 | 5.5E-06 | 1.0E-05 | × | × | A | A |
| A-5 | Al-1at%Si | 4.7E-06 | 3. 4E-06 | 3.4E-06 | ○ | ○ | ○ | ▲ |
| A-6 | Al-1at%Si/Ni | 4.4E-06 | 3.1E-06 | 1.7E-05 | ○ | × | ○ | Δ |
| A-7 | Al-1at%Si/NiSi | 4.4E-06 | 1.1E-05 | 1.2E-05 | × | × | Δ | Δ |
| A-8 | Al-1at%Si/Mo | 4.3E-06 | 3.6E-06 | 3.4E-05 | ○ | × | ○ | ▲ |
| A-9 | Al-1at%Si/Mo/Ni | 4.0E-06 | 3.3E-06 | 4.4E-05 | ○ | × | ○ | ▲ |
| A-10 | Al-1at%Si/Mo/NiSi | 4.0E-06 | 3.4E-06 | 4.1E-05 | ○ | × | ○ | ▲ |
| A-11 | Al-1at%Si/Ti | 4. 3E-06 | 4. 7E-06 | 2.9E-05 | × | × | ○ | ▲ |
| A-12 | Al-1at%Si/Ti/Ni | 4.1E-06 | 4.9E-06 | 2.0E-05 | × | × | Δ | Δ |
| A-13 | Al-1at%Si/Ti/NiSi | 4.0E-06 | 4.0E-06 | 1.4E-05 | ○ | × | Δ | Δ |
| A-14 | Al-1at%Si/TiN | 4.3E-06 | 3.7E-06 | 4.9E-06 | ○ | × | ○ | ▲ |
| A-15 | Al-1at%Si/TiN/Ni | 3.9E-06 | 3.2E-06 | 4.0E-06 | ○ | ○ | ○ | A |
| A-16 | Al-1at%Si/TiN/NiSi | 4.1E-06 | 3.4E-06 | 4.6E-06 | ○ | × | ○ | ▲ |
| B-1 | Cu | 2.3E-06 | 2.0E-06 | 2.0E-06 | ○ | ○ | × | × |
| B-2 | Cu-1at%Ni | 3.8E-06 | 3.6E-06 | 3.4E-06 | ○ | ○ | ○ | ○ |
| B-3 | Cu-1at%Zn | 2.2E-06 | 2.0E-06 | 2.0E-06 | ○ | ○ | ○ | ○ |
| B-4 | Cu-1at%Ti | 1.1E-05 | 6.0E-06 | 4.2E-06 | × | × | ▲ | ▲ |
| B-5 | Cu-1at%Al | 4. 9E-06 | 3.1E-06 | 3.1E-06 | ○ | ○ | ▲ | ▲ |
| B-6 | Cu-1at%Ca | 2.4E-06 | 2.3E-06 | 2.2E-06 | ○ | ○ | ○ | ○ |
| B-7 | Cu-1at%Mn | 6.1E-06 | 2.9E-06 | 2.4E-06 | ○ | ○ | ○ | ○ |
| B-8 | Cu/Mo | 2.4E-06 | 2.0E-06 | 2.0E-06 | ○ | ○ | × | × |
| B-9 | Cu/Mo/NiSi | 2.3E-06 | 2.0E-06 | 2.3E-06 | ○ | ○ | × | × |
| B-10 | Cu-1at%Ni/Mo/NiSi | 4.5E-06 | 3.4E-06 | 3.3E-06 | ○ | ○ | ○ | ○ |
| B-11 | Cu-1at%Zn/Mo/NiSi | 2.9E-06 | 2.0E-06 | 2.0E-06 | ○ | ○ | ○ | ○ |
| B-12 | Cu/TiN | 2.6E-06 | 2.0E-06 | 3.3E-06 | ○ | ○ | × | × |
| B-13 | Cu/TiN/Ni | 2.2E-06 | 2.1E-06 | 1.2E-05 | ○ | × | × | Δ |
| B-14 | Cu/TiN/NiSi | 2.1E-06 | 2.0E-06 | 5.1E-06 | ○ | × | × | × |
| B-15 | Cu-1at%Ni/TiN | 4.0E-06 | 3.6E-06 | 5.1E-06 | ○ | × | ○ | ○ |
| B-16 | Cu-1at%Ni/TiN/Ni | 4.0E-06 | 3.4E-06 | 1.4E-05 | ○ | × | ○ | Δ |
| B-17 | Cu-1at%Ni/TiN/NiSi | 4.8E-06 | 3.6E-06 | 8.2E-06 | ○ | × | ○ | Δ |
| B-18 | Cu-1at%Zn/TiN | 2.1E-06 | 2.0E-06 | 2.9E-06 | ○ | ○ | ○ | ○ |
| B-19 | Cu-1at%Zn/TiN/Ni | 2.5E-06 | 1.9E-06 | 8.5E-06 | ○ | × | ○ | Δ |
| B-20 | Cu-1at%Zn/TiN/NiSi | 2.8E-06 | 2.0E-06 | 3.3E-06 | ○ | ○ | ○ | ○ |

No. B-1 to B-7 in Table 3 show the results of evaluating the heat resistance of the single film of the Cu-based electrode layer 13, that is, the evaluation was conducted for the Cu-based electrode layer 13 produced on a thermal oxide film (silicon oxide film) that was produced on a surface of a silicon substrate and had a film thickness of 100 nm. The Cu-Ti electrode layer of No. B-4 had an electrical resistivity of larger than 4.0 × 10⁻⁶ Ωcm after the heat treatment at 600°C for 5 minutes, and the Cu-Al electrode layer of No. B-5 formed a hillock on a surface thereof. On the other hand, No. B-2 (Cu-Ni), No. B-3 (Cu-Zn), No. B-6 (Cu-Ca), and No. B-7 (Cu-Mn) each had a low electrical resistivity even after the heat treatment at 600°C and were found to be excellent in heat resistance.

No. B-8 to B-11 in Table 3 show the results of evaluating the Cu-based electrode layer 13 with Mo used for the barrier layer 12. Mutual diffusion was suppressed by the Mo barrier layer 12 even after the heat treatment at 600°C for 5 minutes, and the electrode layers exhibited excellent electrical resistivity and heat resistance. The samples did not show a reaction between Cu and Mo even after the heat treatment at 600°C for 5 minutes, and it is clarified that the Mo barrier layer 12 suppressed diffusion of an element from the NiSi ohmic contact layer 11. Further, it is also clarified that addition of an element such as Ni or Zn to the Cu electrode layer 13 is effective in order to improve the heat resistance of the Cu-based electrode layer 13 itself.

No. B-12 to 20 in Table 3 show the results of evaluating the Cu-based electrode layer 13 with TiN used for the barrier layer 12. After the heat treatment at 450°C for 30 minutes, neither an increase in electrical resistivity nor an abnormal surface was observed. For example, as shown by No. B-14, mutual diffusion is found to be generated between the Cu electrode layer 13 and the TiN barrier layer 12 by the heat treatment at 600°C for 5 minutes. Particularly, use of the Ni-based ohmic contact layer 11 gives remarkable diffusion. The reason for this phenomenon is considered to be probably that TiN that is amorphous allows nitrogen to desorb from part of Ti and Ti to contribute to the diffusion. Ti forms an intermetallic compound with each of Cu and Ni, so that either Ti or Ni is assumed to be diffused into the Cu electrode.

On the other hand, No. B-18 to 20 (Cu-Zn electrode layer 13/TiN barrier layer 12) had a smaller increase of the electrical resistivity than in the cases of the Cu electrode layers 13 of No. B-12 and 13. The Cu-Zn electrode layer 13 formed by pre-doping Cu with Zn is assumed to have suppressed diffusion of Ti from TiN. The electrode layer 13 formed of a Cu alloy such as Cu-Zn not only improves the heat resistance but also enables application of the TiN barrier layer 12 to the NiSi ohmic contact layer 11.

### DESCRIPTION OF REFERENCE SYMBOLS

- 1: SiC SUBSTRATE
- 2: EPITAXIAL LAYER
- 3: p-TYPE REGION
- 4: n-TYPE REGION
- 5: INSULATING FILM
- 6: GATE ELECTRODE
- 10: SOURCE ELECTRODE
- 20: DRAIN ELECTRODE
- 11, 21: OHMIC CONTACT LAYER
- 12, 22: BARRIER LAYER
- 13, 23: ELECTRODE LAYER
- 100: SiC-MOSFET

## Claims

1. An ohmic electrode comprising:
an ohmic contact layer formed on a SiC semiconductor layer and formed of a material selected from the group consisting of nickel and nickel silicide;
a barrier layer formed on the ohmic contact layer; and
an electrode layer formed on the barrier layer and formed of a copper alloy containing at least one from among zinc, nickel, titanium, manganese, and calcium.

2. The ohmic electrode according to claim 1, wherein the barrier layer is formed of an element that forms no solid solution with copper or an element that forms a compound with copper.

3. The ohmic electrode according to claim 1, wherein the barrier layer is formed of a material selected from the group consisting of molybdenum, tantalum, tungsten, niobium, titanium, and nitrides of these elements.

4. The ohmic electrode according to claim 1, wherein the electrode layer contains zinc and/or nickel in an amount of 0.1 at% or more and 3 at% or less, titanium in an amount of 0.1 at% or more and 0.5 at% or less, and/or manganese and/or calcium in an amount of 0.1 at% or more and 1 at% or less.

5. The ohmic electrode according to claim 1, wherein the barrier layer has a film thickness of 10 nm or more and 100 nm or less.

6. A SiC semiconductor device comprising the ohmic electrode according to any one of claims 1 to 5.
